# EUROPÄISCHE PATENTSCHRIFT

(11) **EP 3 142 132 B1**
(45) Veröffentlichungstag und Bekanntmachung des Hinweises auf die Patenterteilung: **28.02.2018**
(21) Anmeldenummer: 16188092.7
(22) Anmeldetag: 09.09.2016
(51) Int. Cl.: H01F 27/26, H05K 1/00

(54) **PLANARINDUKTIVITÄT**
PLANAR INDUCTIVITY
INDUCTANCE PLANAIRE

(30) Priorität: 11.09.2015 DE 102015011666
(43) Veröffentlichungstag der Anmeldung: 15.03.2017
(73) Patentinhaber: Leopold Kostal GmbH & Co. KG, 58513 Lüdenscheid (DE)
(72) Erfinder: Neumann, Carsten, 44137 Dortmund (DE)
(74) Vertreter: Kerkmann, Detlef

(56) Entgegenhaltungen:
- JP-A- 2003 324 016
- JP-A- 2005 159 023
- US-B1- 6 326 875

## Beschreibung

Die Erfindung betrifft eine Planarinduktivität, mit einem ebenen Schaltungsträger, mit mindestens einer Spule, die auf dem ebenen Schaltungsträger angeordnet ist, mit einem Spulenkern, bestehend aus einem ersten Kernelement, dessen Schenkel durch Ausnehmungen des Schaltungsträgers hindurchgeführt und dessen Schenkelstirnflächen durch ein zweites Kernelement abgedeckt sind, und mit einem Federelement, durch das das erste Kernelement und das zweite Kernelement aneinander gefügt sind.

Derartige Planarinduktivitäten sind durch beispielsweise aus den Druckschriften JP 2005 159023 A, JP 2003 324016 A und US 6 326 875 B1 bekannt.

Zur Miniaturisierung induktiver Bauelemente wie etwa Drosseln, Übertrager und Transformatoren werden diese zunehmend unter Verwendung eines Schaltungsträgers ausgebildet. Dazu nutzt man Spulen, die auf einer Leiterplatte angeordnet und von einem Ferritkern durchgriffen werden. Häufig wird dabei ein E- oder ein U-Ferrit als ein erstes Kernelement mit einem weiteren E-, U-, oder I-Ferrit als zweitem Kernelement kombiniert, wobei sich diese Bezeichnungen von den Querschnittsformen der Ferrite ableiten. Beide Kernelemente müssen im Gerät, auf der Leiterplatte und aneinander sicher befestigt werden. Eine optimale Befestigung muss preiswert, einfach montierbar und unempfindlich gegenüber den mechanischen Toleranzen sein.

Dabei ist es wichtig, zu verhindern, dass es durch eine falsche Positionierung der Ferrite zueinander zu einer Verengung des magnetischen Flusses kommt. Dies bedeutet konkret, dass die Stirnflächen der Schenkel an den E- oder U-Ferriten vollständig durch den Gegenferrit, also beispielsweise durch einen I-Ferrit, abgedeckt sein müssen.

Dabei stellte sich das Problem der sicheren Befestigung und der genauen Positionierung der beiden Ferritkernelemente. Bekannt ist das Verkleben oder das Verklammern beider Teile. Diese Arten der Verbindung von Kernelementen haben verschiedene Nachteile. Die Klebevariante ist prozesstechnisch aufwändig durch die Applikation des Klebers, Beachtung des Aushärtevorgangs und des dabei zu berücksichtigen Zeitaufwands. Der aufgebrachte Klebstoff beeinflusst zudem den Abstand zwischen den Kernelementen und vergrößert außerdem einen gegebenenfalls vorhandenen Luftspalt. Die Klammervariante kann schwierig in der Montage sein.

Die deutsche Patentschrift DE 198 08 592 C2 zeigt in ihrer Figur 6 eine Planarinduktivität, bei der zwei Kernelemente durch ein annähernd M-förmiges federndes Klammerelement zusammengehalten werden. Dabei sind zwei Schenkel des Klammerelements neben den seitlichen Außenflächen der Kernelemente durch Ausnehmungen des Schaltungsträgers hindurchgeführt. Die Befestigung eines derartigen Klammerelements kann recht aufwändig sein, insbesondere dann, wenn der Schaltungsträger mit weiteren elektrischen Bauelementen eng bestückt ist. In diesem Dokument wird auch vorgeschlagen, Kernelemente durch Kleben aneinander zu befestigen.

Es stellte sich die Aufgabe, eine Planarinduktivität zu schaffen, die eine einfache, platzsparende, toleranzunempfindliche und positionsgenaue Ferritkernbefestigung ermöglicht, welche sich auch gut für eine automatische Montage eignet.

Diese Aufgabe wird erfindungsgemäß durch eine Planarinduktivität gemäß vorliegendem Anspruch 1 gelöst.

Die erfindungsgemäße Planarinduktivität weist somit einen Führungsrahmen auf, welcher die beiden Ferritkernelemente mittels angeformter Führungselemente seitlich aneinander so ausrichten, dass die Stirnflächen der Schenkel des ersten Kernelements vom zweiten Kernelement vollständig überdeckt sind. Zum Ausgleich von Maßtoleranzen sind vorzugsweise einige Führungselemente über Federarme an den Führungsrahmen befestigt.

Um eine vollständige Abdeckung der Schenkelstirnflächen des ersten Kernelements durch das zweite Kernelement zu ermöglichen, wird bevorzugt vorausgesetzt, dass die Seitenabmessungen des zweiten Kernelements unter Berücksichtigung möglicher Maßtoleranzen, mindestens gleichgroß zu den entsprechenden Abmessungen des ersten Kernelements sind. Vorzugsweise werden die seitlichen Abmessungen des zweiten Kernelements sogar etwas größer vorgesehen. Die Führungselemente, die vorzugsweise als Führungsrippen ausgebildet sind, erlauben so entweder ein seitliches Überstehen des zweiten Kernelements oder maximal eine bündige Ausrichtung der Seitenflächen des ersten und des zweiten Kernelements. Der Führungsrahmen verhindert damit sicher, dass Schenkelstirnflächen des ersten Kernelements unvollständig vom zweiten Kernelement überdeckt sind.

Zur Befestigung des Führungsrahmens und der Ferritkernelemente ist ein Federelement vorgesehen, das auf den Führungsrahmen eine Kraft ausübt, welche den Führungsrahmen gegen die Ferritkernelemente, und die beiden Ferritkernelemente gegeneinander und gegen eine Anlagefläche, beispielsweise in einem Gehäuse, presst. Das Federelement ist vorzugsweise als eine fingerförmige Blattfeder ausgebildet.

Besonders vorteilhaft ist es, wenn das Federelement als sogenannte Vielfingerfeder ausgebildet ist, welche einstückig mehrere fingerförmige Blattfedern aufweist, die man einfach an verschiedene Bauraumsituationen, Befestigungskräfte und zu befestigende Bauteile anpassen kann. In diesem Fall kann beispielsweise der Führungsrahmen eines Spulenkerns seitlich durch zwei Finger der Vielfingerfeder abgestützt werden, da im Falle eines des mittig angeordneten Kernluftspaltes im E-Kern und des üblicherweise spröden Ferritmaterials eine mittige Beanspruchung durch eine Biegebelastung ungünstig ist.

Ferrite bestehen zumeist aus gesintertem Keramikmaterial, das empfindlich auf Kräfte reagiert, die punktuell oder linienförmig aufgebracht werden. Der Führungsrahmen schützt die Ferrite, indem die genannten Kräfte flächig in das Ferritmaterial eingeleitet werden.

Eine Vielfingerfeder ermöglicht zudem vorteilhafterweise die gleichzeitige Fixierung mehrerer Planarinduktivitäten, und kann darüber hinaus weitere Funktionen übernehmen, wie beispielsweise Befestigung, Abschirmung, und das Anpressen von Bauteilen auf dem Schaltungsträger gegen ein Gehäuse, um die Kühlung zu erleichtern.

Die Erfindung soll nachfolgend anhand der Zeichnung dargestellt und näher erläutert werden. Es zeigen
- Figur 1: den Aufbau einer erfindungsgemäßen Planarinduktivität mit einem Gehäuseabschnitt in einer Schnittansicht,
- Figur 2: einen Spulenkern mit Führungsrahmen,
- Figuren 3, 4: Ansichten einer Planarinduktivität an der Ober- und Unterseite eines Schaltungsträgers,
- Figur 5: ein Führungsrahmen als Einzelteil,
- Figur 6: mehrere auf einem Schaltungsträger befestigte Planarinduktivitäten und eine an mehreren Stellen gegen ein Gehäuse fixierte Leiterplatte durch eine Blattfeder,
- Figur 7: eine Planarinduktivität nach dem Stand der Technik.

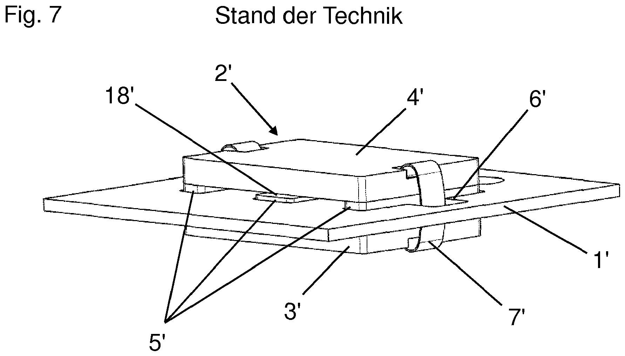

Zur Erläuterung des zur Erfindung führenden Problems zeigt die Figur 7 eine Planarinduktivität nach dem Stand der Technik. Diese besteht aus einer oder mehreren, hier nicht dargestellten Spulen, die durch Leiterbahnen auf einem Schaltungsträger 1' ausgebildet sind. Diese Spulen sind um die Schenkel 5' eines geschlossenen Spulenkerns 2' herum angeordnet, der aus einem E-förmigen Kernelement 3' und einem I-förmiges Kernelement 4' zusammengesetzt ist. Die Kernelemente 3', 4' bestehen beide aus Ferritmaterial und werden daher hier auch kurz als E-Ferrit 3' und I-Ferrit 4' bezeichnet.

Die drei Schenkel 5' des E-Ferrits 3' sind durch Ausnehmungen 6' des Schaltungsträgers 1' hindurchgeführt. Durch den aufgesetzten I-Ferrit 4 ist der E-Ferrit 3 am Schaltungsträger 1' zu einer geschlossenen Magnetkernanordnung komplettiert. In der dargestellten Ausführung ist am mittleren Schenkel 5' ein Luftspalt 18' vorgesehen.

Um den E-Ferrit 3' mit dem I-Ferrit 4' mechanisch zu verbinden, ist an den Schmalseiten der beiden Ferrite 3', 4' jeweils eine Federklammer 7' montiert, die an den außenliegenden Oberflächen der beiden Ferrite 3', 4' angreifen und diese federnd miteinander verklammern.

Zur Montage werden die Federklammern 7' jeweils in eine Ausnehmung 6' des Schaltungsträgers 1' eingeschoben und dann auf beiden Seiten des Schaltungsträgers 1' mit jeweils einem der Ferrite 3', 4' verbunden. Die Montage ist recht aufwändig, und zwar insbesondere dann, wenn auf dem Schaltungsträger 1' weitere Bauelemente dicht gepackt angeordnet sind. Durch die relativ schwierige Montage ist auch der dazu erforderliche Zeit- und Kostenaufwand relativ hoch. Dieses ist besonders dann nachteilig und teuer, wenn ein elektrisches Gerät mehrere solcher Planarinduktivitäten aufweisen soll.

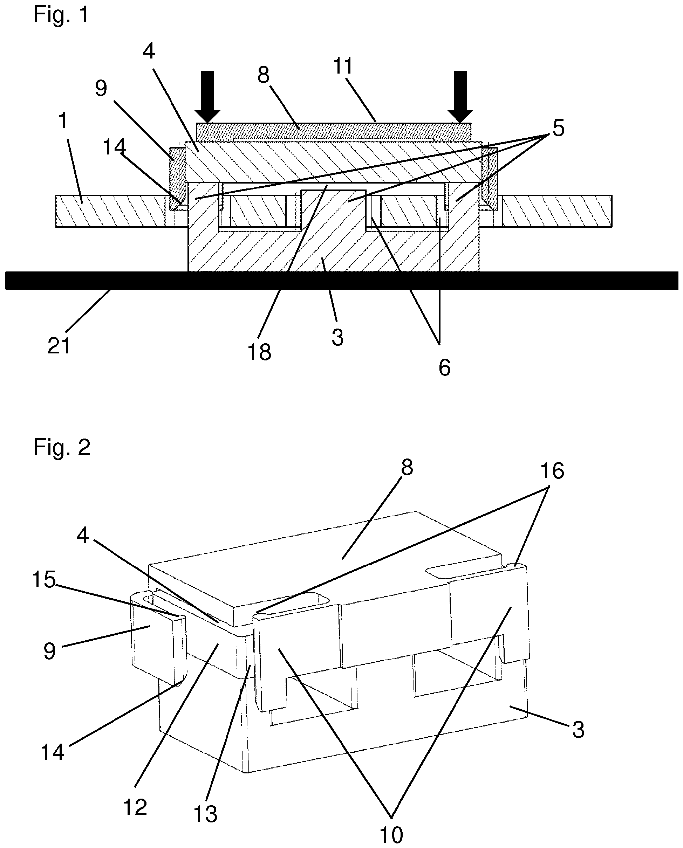

Der Aufbau einer erfindungsgemäß ausgeführten Planarinduktivität wird durch die Figur 1 in einer Schnittansicht beispielhaft verdeutlicht. Ein dreischenkliger E-Ferrit 3 liegt mit seiner Grundfläche an einer inneren Fläche 21 eines Gehäuses an. Je nach Anwendungsfall sind andere Ferritformen möglich. Beispielsweise kann statt des dreischenkligen E-Ferrits 3 auch ein zweischenkliger U-Ferrit vorgesehen werden. Dies führt zu einem analogen Aufbau, ist aber in der Zeichnung nicht dargestellt.

Auf den E-Ferrit 3 ist ein Schaltungsträger 1 derart aufgesetzt, dass die Schenkel 5 des E-Ferrits 3 durch Ausnehmungen 6 des Schaltungsträgers 1 hindurchgeführt sind. Der E-Ferrit 3 ist dadurch an eine oder mehrere als Leiterbahnen auf dem Schaltungsträger 1 angeordnete Spulen angekoppelt. Der Schaltungsträger 1 wird üblicherweise durch eine Leiterplatte ausgebildet, kann aber auch durch einen keramischen Träger, eine flexible Leiterfolie oder ähnliches ausgeführt sein. Die mindestens eine Spule kann alternativ auch durch ein Stanzgitter, Draht, Litze oder Hochfrequenzlitze ausgebildet sein.

Auf die Stirnflächen der aus dem Schaltungsträger 1 herausragenden äußeren Schenkel 5 des E-Ferrits 3 ist ein I-Ferrit 4, der den magnetischen Kreis schließt, lose aufgesetzt. An den I-Ferrit 4 ist ein Führungsrahmen 8 angefügt.

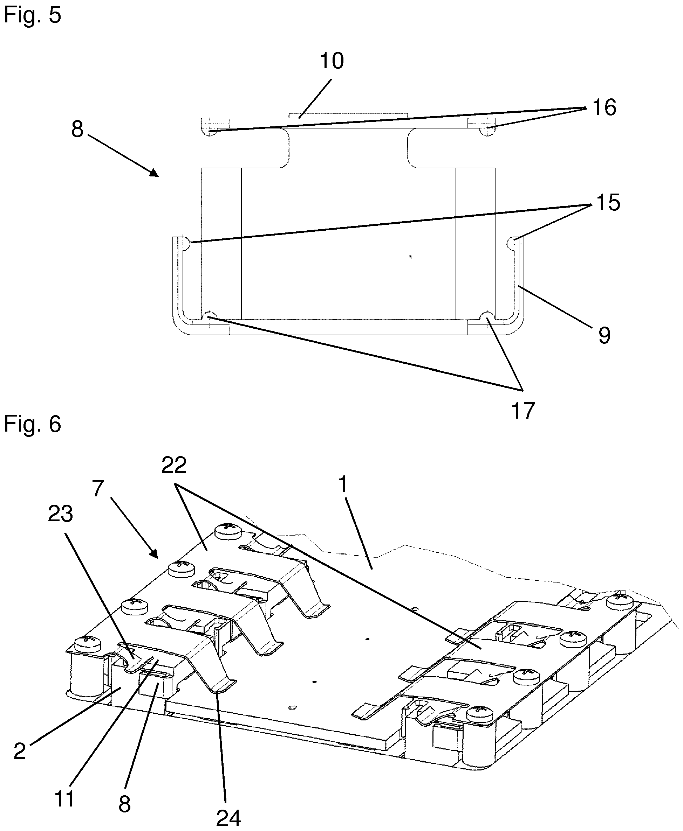

Der Aufbau und die Funktion des Führungsrahmens 8 werden durch die Figuren 2 und 5 weiter verdeutlicht. Der hier dargestellte Führungsrahmen 8 ist selbstverständlich eine nur beispielhafte Ausführungsform.

Der Führungsrahmen 8 weist an seinen Seiten mehrere einstückig angeformte Federarme 9, 10 auf, an deren Endabschnitten jeweils senkrecht zur Federarmlängsachse mechanische Führungselemente 15, 16 angeformt sind, welche hier beispielhaft rippenförmig ausgebildet sind und an Seitenflächen 12, 13 des I-Ferrits anliegen. Zum Ausgleich von Maßtoleranzen können weitere Führungselemente 17 nichtfedernd am Führungsrahmen 8 angeformt sein, was in der Figur 5 dargestellt ist. In einer hier nicht dargestellten alternativen Ausführungsform können die Führungselemente beispielsweise auch als halbrunde Kufen ausgeführt sein.

Die Führungselemente 15, 16, 17 liegen an mindestens einer Schmalseitenfläche 12 und einer Längsseitenfläche 13 des I-Ferrits 4 an und erstrecken sich in der Aufbaurichtung der Kernelemente 3, 4 über diese Seitenflächen 12, 13 hinaus in Richtung auf den E-Ferrit 3. Hierdurch können die Führungselemente 15, 16, 17 den I-Ferrit 4 am darunter liegenden E-Ferrit 3 ausrichten.

Die mechanische Fixierung der in der Figur 1 dargestellten Anordnung kann vorteilhaft durch zwei Blattfedern 23 der in der Figur 6 dargestellten Vielfingerfeder 22 erfolgen. Die Krafteinwirkung dieser in der Figur 1 nicht dargestellten Federn auf die Außenfläche 11 des Führungsrahmens 8 erfolgt vorzugsweise an den durch zwei Pfeile gekennzeichneten Stellen, und damit dort, wo die beiden Kernelemente 3, 4 dicht aufeinanderliegen.

Eine Federbefestigung in der Mitte des Führungsrahmens wäre hier aufgrund des am mittleren Schenkel 5 des E-Ferrits vorgesehenen Luftspalts 18 ungünstig, da der I-Ferrit 4 dadurch auf Biegung belastet würde und brechen könnte.

Der Führungsrahmen 8 besteht entweder aus einem federnden Metall oder vorzugsweise aus einem Kunststoff. Wesentlich ist, dass nach dem Zusammenfügen des Führungsrahmens 8 mit den beiden Kernelementen 3, 4 die Führungselemente 15 an den Schmalseitenflächen 12 des I-Ferrits 4 und die Führungselemente 16, 17 an den Längsseitenflächen 13 des I-Ferrits 4 anliegen, um eine Ausrichtung des I-Ferrits 4 zum E-Ferrit entlang seiner Auflagefläche zu bewirken.

Vorteilhafterweise wirken die Federarme 9, 10 des Führungsrahmens 8 am I-Ferrit 4 als eine federnde Klammer, so dass der Führungsrahmen 8 leicht auf dem I-Ferrit 4 fixiert ist und beide gemeinsam auf den E-Ferrit 3 geschoben werden können ohne daß der I-Ferrit 4 herausfällt. Um ein einfaches Aufschieben des Führungsrahmens 8 auf den I-Ferrit 4 zu ermöglichen, sind in der Montagerichtung Einführschrägen 14 an die Federarme 9, 10 angeformt.

Für die optimale Funktion der Planarinduktivität ist unbedingt sicherzustellen, dass der I-Ferrit 4 den E-Ferrit 3 vollständig abdeckt, um eine Verengung des magnetischen Flusses und die Erzeugung von Streufeldern zu vermeiden. Daher müssen in der Berührungsebene der Ferrite 3, 4 die Kleinstmaße des I-Ferrits 4 mindestens gleich den Größtmaßen des E-Ferrits 3 sein, um eine Abdeckung unter allen möglichen Toleranzen sicherzustellen. Das führt dazu, dass der I-Ferrit 4 sowohl in seiner Längs- als auch in seiner Querrichtung ein leichtes Übermaß gegenüber dem E-Ferrit 3 aufweist, so dass der I-Ferrit 4 nach dem Aufsetzen auf den E-Ferrit 3 sowohl an der Längsseite als auch an der Schmalseite über mindestens einen Rand des E-Ferrits 3 herausragt. Für die Längsseitenrichtung ist dieses in der in der Figur 1 erkennbar.

Durch der Führungsrahmen 8 wird der I-Ferrit 4 schwimmend auf dem E-Ferrit 3 gehalten, wodurch sich der I-Ferrit 4 vor seiner Fixierung durch ein Federelement 7 in den seitlichen Richtungen, soweit es die am I-Ferrit 4 anliegenden Führungselemente 15, 16, 17 zulassen, bewegen kann. Der I-Ferrit 4 kann sich dabei höchstens bündig zum E-Ferrit 3 ausrichten, da andernfalls die über die Außenränder des I-Ferrits 4 überstehenden Führungselemente 15, 16, 17 auf die Außenränder des E-Ferrits 3 treffen. Die Federkraft der Federarme 9, 10 muss groß genug sein, um eine sicheres Abdecken der Schenkelflächen des E-Ferrits 3 zu erreichen.

Die Anordnung des I-Ferrits 4 auf dem E-Ferrit 3, wird abschließend durch eine senkrecht auf die Außenfläche 11 des Führungsrahmens 8 und den Spulenkern 2 wirkende Federkraft vorzugsweise über einen Reibschluss zwischen den Ferriten 3, 4 fixiert. Der Reibschluss sollte idealerweise so groß sein, dass eine sichere Fixierung des gesamten Aufbaus quer und längs zur Anpresskraft auch unter Belastungen, wie etwa Vibrationen und Beschleunigungen, sichergestellt ist.

Die Figur 6 zeigt eine Anordnung von beispielhaft sechs Planarinduktivitäten auf einem gemeinsamen Schaltungsträger 1. Teilweise erkennbar sind die Spulenkerne 2 und die Führungsrahmen 8 der Planarinduktivitäten. Zur federnden Fixierung dieser Komponenten sind zwei Vielfingerfedern 22 vorgesehen, die jeweils mit hier nicht näher dargestellten Teilen eines Gehäuses verschraubt sind.

Die Vielfingerfedern 22 bilden einstückig abwechselnd kurze und lange Blattfedern 23, 24 aus, wobei sich die langen Blattfedern 24 auf dem Schaltungsträger 1 und die kurzen Blattfedern 23 auf den Außenflächen der Führungsrahmen 8 mehrerer Planarinduktivitäten abstützen und diese durch ihre Federkraft fixieren.

Durch einfaches Anschrauben einer Vielfingerfeder 22 werden so die Komponenten gleich mehrerer Planarinduktivitäten federnd aneinander fixiert. Die langen Blattfedern 24, die auf dem Schaltungsträger 1 aufliegen, dienen unter anderem zur schwimmenden Befestigung des Schaltungsträgers 1, was hinsichtlich einer möglichen thermischen Ausdehnung des Schaltungsträgers 1 vorteilhaft ist. Darüber hinaus können die langen Blattfedern 24 zur thermischen Ankopplung und damit zur Entwärmung auch Bereiche der Leiterplatte an das darunterliegende Gehäuse oder an einen Kühlkörper andrücken.

Die während der Montage benötigte seitliche Führungs- und Ausrichtfunktion des Führungsrahmens 8 ist prinzipiell nach der Montage nicht mehr erforderlich. Daher kann der Führungsrahmen 8 aus einem vergleichsweise kostengünstigen Kunststoff hergestellt werden, der sich zudem vorteilhafterweise gegenüber dem magnetischen Fluss neutral verhält.
Sofern für die vorgesehene Ausführungsform einer Planarinduktivität die durch die Federarme einer Führungsrahmen aus Kunststoff aufgebrachten Federkräfte nicht ausreichend sind, können die Federarme und damit die gesamte Führungsrahmen auch aus einem nichtmagnetischem Metall mit Federeigenschaften hergestellt werden. In diesem Fall kann der Führungsrahmen vorzugsweise als ein Stanzbiegeteil ausgeführt werden.

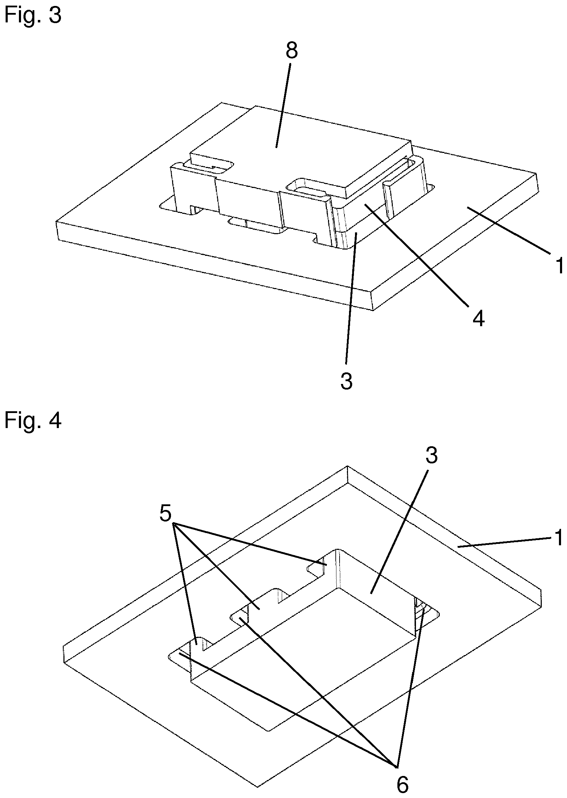

Die Figuren 3 und 4 zeigen zur weiteren Veranschaulichung jeweils die Oberseite und die Unterseite des Schaltungsträgers 1 einer Planarinduktivität. An der Oberseite des Schaltungsträgers 1 ist der auf die beiden Kernelemente 3, 4 aufgesetzte Führungsrahmen 8 erkennbar. Beim Blick auf Unterseite des Schaltungsträgers 1 ist das E-förmige Kernelement 3 ersichtlich, dessen Schenkel 5 Ausnehmungen des Schaltungsträgers 1 durchgreifen. Der Vergleich mit der in der Figur 7 dargestellten bekannten Ausführung zeigt, dass hier keine Haltemittel beidseitig des Schaltungsträgers 1 an den Kernelementen 3, 4 zu befestigen sind, wodurch die Montage gegenüber vorbekannten Ausführungen wesentlich vereinfacht ist.

### Bezugszeichen

- 1, 1': Schaltungsträger
- 2, 2': Spulenkern
- 3, 3': Kernelement (E-Ferrit)
- 4, 4': Kernelement (I-Ferrit)
- 5, 5': Schenkel
- 6, 6': Ausnehmungen
- 7, 7': Federelement
- 8: Führungsrahmen
- 9: Erste Federarme
- 10: Zweite Federarme
- 11: Außenfläche
- 12: erste Seitenfläche (Schmalseitenfläche)
- 13: zweite Seitenfläche (Längsseitenfläche)
- 14: Einführschräge
- 15, 16, 17: Führungselemente (Führungsrippen)
- 18, 18': Luftspalt
- 21: Gehäusefläche (Grundfläche)
- 22: Vielfingerfeder
- 23: (kurze) Blattfedern
- 24: (lange) Blattfedern

## Patentansprüche

1. Planarinduktivität,
mit einem ebenen Schaltungsträger (1), mit mindestens einer Spule, die auf dem ebenen Schaltungsträger angeordnet ist, mit einem Spulenkern (2), bestehend aus einem ersten Kernelement (3), dessen Schenkel (5) durch Ausnehmungen (6) des Schaltungsträgers hindurchgeführt und dessen Schenkelstirnflächen durch ein zweites Kernelement (4) des Spulenkerns abgedeckt sind, und mit einem Federelement (7) durch das das erste Kernelement und das zweite Kernelement aneinander gefügt sind,
**dadurch gekennzeichnet,**
**dass** die Planarinduktivität einen Führungsrahmen (8) mit angeformten Führungselementen (15, 16, 17) aufweist, der auf das zweite Kernelement (4) aufgesetzt ist,
**dass** die Führungselemente (15, 16, 17) mindestens an zwei nichtparallelen Seitenflächen (12, 13) des zweiten Kernelements (4) anliegen, und sich über die Seitenflächen (12, 13) hinaus senkrecht in Richtung auf das erste Kernelement (3) erstrecken, und dass das Federelement (7) Mittel zur externen Abstützung aufweist, wodurch das Federelement den Führungsrahmen (8) gegen den Spulenkern (2) und den Spulenkern (2) gegen eine Grundfläche (21) eines Gehäuses, an der die Planarinduktivität anordenbar ist, pressen kann.

2. Planarinduktivität nach Anspruch 1, **dadurch gekennzeichnet, dass** die mindestens eine Spule durch die Leiterbahnanordnung auf dem Schaltungsträger (1) ausgebildet ist.

3. Planarinduktivität nach Anspruch 1, **dadurch gekennzeichnet, dass** das erste Kernelement (3) im Querschnitt U- oder E-förmig ausgebildet ist.

4. Planarinduktivität nach Anspruch 1, **dadurch gekennzeichnet, dass** das zweite Kernelement (4) im Querschnitt U-, E- oder I-förmig ausgebildet ist.

5. Planarinduktivität nach Anspruch 1, **dadurch gekennzeichnet, dass** die Kernelemente (3, 4) als Ferrite ausgebildet sind.

6. Planarinduktivität nach Anspruch 1, **dadurch gekennzeichnet, dass** der Führungsrahmen (8) aus Kunststoff oder Metall besteht.

7. Planarinduktivität nach Anspruch 1, **dadurch gekennzeichnet, dass** die Führungselemente (15, 16, 17) rippenförmig ausgebildet sind.

8. Planarinduktivität nach Anspruch 1, **dadurch gekennzeichnet, dass** der Führungsrahmen (8) mindestens zwei angeformte Federarme (9, 10) mit daran angeordneten Führungselementen (15, 16) aufweist.

9. Planarinduktivität nach Anspruch 1, **dadurch gekennzeichnet, dass** das Federelement (7) als eine fingerförmige Blattfeder (23) ausgebildet ist.

10. Planarinduktivität nach Anspruch 1, **dadurch gekennzeichnet, dass** das Federelement (7) durch mehrere fingerförmige Blattfedern (23, 24) ausgebildet ist, die einstückig miteinander verbunden sind.

11. Planarinduktivität nach Anspruch 10, **dadurch gekennzeichnet, dass** das Federelement (7) fingerförmige Blattfedern (23, 24) in mindestens zwei unterschiedlichen Längen aufweist.

## Claims

1. Planar inductor
having a flat circuit carrier (1),
having at least one coil located on the flat circuit carrier,
having a coil core (2) consisting of a first core element (3) whose leg (5) leads through cut-outs (6) in the circuit carrier and whose front leg surfaces are covered by a second core element (4) of the coil core,
and having a spring element (7) by means of which the first core element and the second core element are joined to each other,
**characterised in that**
the planar inductor has a guide frame (8) with integrally moulded guide elements (15, 16, 17) which is placed on the second core element (4),
that the guide elements (15, 16, 17) fit closely against at least two non-parallel lateral surfaces (12, 13) of the second core element (4) and extend vertically beyond the lateral surfaces (12, 13) towards the first core element (3), and
that the spring element (7) has a means for external support as a result of which the spring element can press the guide frame (8) against the coil core (2) and the coil core (2) against a base area (21) of a housing on which the planar inductor is positionable.

2. Planar inductor according to Claim 1, **characterised in that** the at least one coil is formed by the printed conductor arrangement on the circuit carrier (1).

3. Planar inductor according to Claim 1, **characterised in that** the first core element (3) is designed with a U-shaped or an E-shaped cross-section.

4. Planar inductor according to Claim 1, **characterised in that** the second core element (4) is designed with a U-shaped, an E-shaped or an I-shaped cross-section.

5. Planar inductor according to Claim 1, **characterised in that** the core elements (3, 4) are designed as ferrites.

6. Planar inductor according to Claim 1, **characterised in that** the guide frame (8) is made of plastic or metal.

7. Planar inductor according to Claim 1, **characterised in that** the guide elements (15, 16, 17) are of a rib-shaped design.

8. Planar inductor according to Claim 1, **characterised in that** the guide frame (8) has at least two integral spring arms (9, 10) with guide elements (15, 16) positioned on the same.

9. Planar inductor according to Claim 1, **characterised in that** the spring element (7) is designed as a finger-shaped leaf spring (23).

10. Planar inductor according to Claim 1, **characterised in that** the spring element (7) is formed by a plurality of finger-shaped leaf springs (23, 24) which are integrally connected to each other.

11. Planar inductor according to Claim 10, **characterised in that** the spring element (7) has finger-shaped leaf springs (23, 24) in at least two different lengths.

## Revendications

1. Inductance planaire,
avec un support de circuits plan (1),
avec au moins une bobine, qui est disposée sur le support de circuits plan, avec un noyau de bobine (2) qui consiste en un premier élément de noyau (3), dont la branche (5) est conduite à travers des évidements (6) du support de circuits, et dont les faces frontales de branche sont recouvertes par un deuxième élément de noyau (4) du noyau de bobine,
et avec un élément faisant ressort (7), par lequel le premier élément de noyau et le deuxième élément de noyau sont assemblés,
**caractérisée en ce que**
l'inductance planaire présente un cadre de guidage (8) doté d'éléments de guidage (15, 16, 17), formés à partir de lui, lequel est installé sur le deuxième élément de noyau (4),
les éléments de guidage (15, 16, 17) portent, au moins contre deux faces latérales non parallèles (12, 13) du deuxième élément de noyau (4) et s'étendent au-delà des faces latérales (12, 13), verticalement, vers le premier élément de noyau (3),
l'élément faisant ressort (7) présente des moyens de soutien extérieur, ce en raison de quoi l'élément faisant ressort peut presser le cadre de guidage (8) contre le noyau de bobine (2) et le noyau de bobine (2) contre une face de base (21) d'un boîtier, sur laquelle l'inductance planaire peut être disposée,

2. Inductance planaire selon la revendication 1, **caractérisée en ce que** l'au moins une bobine est formée par l'agencement de pistes conductrices sur le support de circuits (1).

3. Inductance planaire selon la revendication 1, **caractérisée en ce que** le premier élément de noyau (3) est réalisé avec une section transversale en U ou en E.

4. Inductance planaire selon la revendication 1, **caractérisée en ce que** le deuxième élément de noyau (4) est réalisé avec une section transversale en U, en E ou en I.

5. Inductance planaire selon la revendication 1, **caractérisée en ce que** les éléments de noyau (3, 4) sont réalisés en ferrite.

6. Inductance planaire selon la revendication 1, **caractérisée en ce que**, le cadre de guidage (8) consiste en matière synthétique ou en métal.

7. Inductance planaire selon la revendication 1, **caractérisée en ce que** les éléments de guidage (15, 16, 17) sont réalisés en forme de nervures.

8. Inductance planaire selon la revendication 1, **caractérisée en ce que** le cadre de guidage (8) présente au moins deux bras faisant ressort (9, 10), qui, formés à partir de lui, présentent des éléments de guidage (15, 16) y disposés.

9. Inductance planaire selon la revendication 1, **caractérisée en ce que** l'élément faisant ressort (7) est réalisé en tant que ressort à lames en forme de doigt (23).

10. Inductance planaire selon la revendication 1, **caractérisée en ce que**
l'élément faisant ressort (7) est formé par plusieurs ressorts à lames en forme de doigts (23, 24), qui sont reliés ensemble en une pièce.

11. Inductance planaire selon la revendication 10, **caractérisée en ce que**
l'élément faisant ressort (7) présente des ressorts à lames (23, 24) en forme de doigts d'au moins deux longueurs différentes.
